(19) **Europäisches Patentamt / European Patent Office / Office européen des brevets**

(11) **EP 3 998 647 B1**

(12) # EUROPEAN PATENT SPECIFICATION

(45) Date of publication and mention
of the grant of the patent:
**31.12.2025 Bulletin 2026/01**

(21) Application number: **22150489.7**

(22) Date of filing: **13.06.2018**

(51) International Patent Classification (IPC):
**H10D 1/47** (2025.01) **H03F 3/45** (2006.01)

(52) Cooperative Patent Classification (CPC):
**H10D 1/47; H03F 3/45475; H03F 3/45937;**
H03F 2203/45228; H03F 2203/45426;
H03F 2203/45594

(54) **IMPEDANCE CIRCUIT WITH POLY-RESISTOR**

IMPEDANZSCHALTUNG MIT POLYWIDERSTAND

CIRCUIT D'IMPÉDANCE À POLY-RÉSISTANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.09.2017 US 201715693548
09.11.2017 US 201762583576 P
16.04.2018 US 201815953772**

(43) Date of publication of application:
**18.05.2022 Bulletin 2022/20**

(62) Document number(s) of the earlier application(s) in
accordance with Art. 76 EPC:
**18177526.3 / 3 451 398**

(73) Proprietor: **MEDIATEK INC.
Hsinchu City 30078 (TW)**

(72) Inventors:
• **WEN, Sung-Han
103 Taipei City (TW)**
• **CHEN, Kuan-Ta
300 Hsinchu City (TW)**

(74) Representative: **Wright, Howard Hugh Burnby
Withers & Rogers LLP
2 London Bridge
London SE1 9RA (GB)**

(56) References cited:
**US-A1- 2009 002 120     US-A1- 2009 085 657
US-A1- 2011 248 787**

• **AZZOLINI C ET AL: "Very low-cost CMOS audio amplifier for 1-V portable applications", DESIGN AND TECHNOLOGY OF INTEGRATED SYSTEMS IN NANOSCALE ERA, 2008. DTIS 2008. 3RD INTERNATIONAL CONFERENCE ON, IEEE, PISCATAWAY, NJ, USA, 25 March 2008 (2008-03-25), pages 1 - 4, XP031270346, ISBN: 978-1-4244-1576-2**
• **PUI-IN MAK ET AL: "On the Design of a Programmable-Gain Amplifier With Built-In Compact DC-Offset Cancellers for Very Low-Voltage WLAN Systems", IEEE TRANSACTIONS ON CIRCUITS AND SYSTEMS I: REGULAR PAPERS, IEEE, US, vol. 55, no. 2, 2 March 2008 (2008-03-02), pages 496 - 509, XP011333055, ISSN: 1549-8328, DOI: 10.1109/TCSI.2007.910643**
• **LOPEZ-MARTIN A J ET AL: "Class AB differential difference amplifier for enhanced common-mode feedback", ELECTRONICS LETTERS, IEE STEVENAGE, GB, vol. 53, no. 7, 30 March 2017 (2017-03-30), pages 454 - 456, XP006074910, ISSN: 0013-5194, DOI: 10.1049/EL.2017.0347**
• **DE LA PLAZA A. ET AL: "Power-supply rejection in differential switched-capacitor filters", IEEE JOURNAL OF SOLID-STATE CIRCUITS, 1 December 1984 (1984-12-01), New York, NY, pages 912 - 918, XP093141758, Retrieved from the Internet <URL:https://ieeexplore.ieee.org/stampPDF/getPDF.jsp?tp=&arnumber=1052245&ref=aHR0cHM6Ly93d3cuZ29vZ2xlLmNvbS8=> [retrieved on 20240315], DOI: 10.1109/JSSC.1984.1052245** ➨**Missing tag: [B566EP]** **20220602**

EP 3 998 647 B1

## Description

Field of the Invention

The disclosure generally relates to an impedance circuit, and more specifically, to an impedance circuit and poly-resistors therein.

## Description of the Related Art

Poly-resistors are characterized by their sheet resistance values. In order to reduce the chip size, the poly-resistors with high sheet resistance values are often used and fabricated in a small area, and they are extensively used in a variety of integrated circuits.

However, the depletion effect is a phenomenon in which there is unwanted variation in the threshold voltage of devices using poly-silicon as a gate material, leading to unpredictable behavior on the part of electronic circuits. It results in serious non-linearity of the poly-resistors. Accordingly, there is a need for a novel solution for suppressing the non-ideal depletion effect in poly-resistors.

Azzolini C et al., "Very low-cost CMOS audio amplifier for I-V portable applications", Design and Technology of Integrated Systems in Nanoscale Era, 2008, DTIS 2008, 3rd International Conference on, IEEE, Piscataway, NJ, USA, 25 March 2008, pages 1 to 4, discloses a design for a low cost, full-analog, audio amplifier IC for hearing aid devices.

Pui-In Mak et al., "On the Design of a Programmable-Gain Amplifier with Built-In Compact DC-Offset Cancellers for Very Low-Voltage WLAN Systems", IEEE Transactions on Circuits and Systems I: Regular Papers, IEEE, US, vol. 55, no. 2, 2 March 2008, pages 496 to 509, discloses circuit techniques adopted in the design of an embedded programmable-gain amplifier for very low-voltage wireless local-area network systems.

US 2011/248787 discloses a varactor circuit with voltage-controlled oscillation.

## BRIEF SUMMARY OF THE INVENTION

The present invention is defined by the independent claim 1. Further advantageous embodiments are defined in the dependent claims 2-4.

## BRIEF DESCRIPTION OF DRAWINGS

The invention can be more fully understood by reading the subsequent detailed description and examples with references made to the accompanying drawings, wherein:

FIG. 1 is a diagram of an impedance circuit according to an embodiment of the invention;

FIG. 2 is a diagram of a poly-resistor according to an embodiment of the invention;

FIG. 3 is a diagram of a poly-resistor according to an embodiment of the invention;

FIG. 4 is a diagram of a poly-resistor according to an embodiment of the invention;

FIG. 5A is a diagram of an impedance circuit according to an embodiment of the invention;

FIG. 5B is a diagram of an impedance circuit according to another embodiment of the invention;

FIG. 6A is a diagram of a differential or pseudo-differential amplifier according to an embodiment of the invention;

FIG. 6B is a diagram of a differential or pseudo-differential amplifier according to an embodiment not covered by the claims.

FIG. 6C is a diagram of a differential or pseudo-differential amplifier according to an embodiment not covered by the claims.

FIG. 6D is a diagram of a differential or pseudo-differential amplifier according to an embodiment not covered by the claims.

FIG. 7A is a diagram of a differential-to-single-ended amplifier according to an embodiment not covered by the claims.

FIG. 7B is a diagram of a differential-to-single-ended amplifier according to an embodiment not covered by the claims.

FIG. 7C is a diagram of a differential-to-single-ended amplifier according to an embodiment not covered by the claims.

FIG. 7D is a diagram of a differential-to-single-ended amplifier according to an embodiment not covered by the claims.

FIG. 8A is a diagram of an inverting amplifier according to an embodiment not covered by the claims.

FIG. 8B is a diagram of an inverting amplifier according to an embodiment not covered by the claims.

FIG. 8C is a diagram of an inverting amplifier according to an embodiment not covered by the claims.

FIG. 9 is a diagram of an impedance circuit according to another embodiment of the invention;

FIG. 10 is a diagram of an impedance circuit according to another embodiment of the invention;

FIG. 11 is a diagram of an impedance circuit according to another embodiment of the invention; and

FIG. 12 is a diagram of an impedance circuit according to another embodiment of the invention.

## DETAILED DESCRIPTION OF THE INVENTION

In order to illustrate the purposes, features and advantages of the invention, the embodiments and figures of the invention will be described in detail as follows.

Certain terms are used throughout the description and following claims to refer to particular components. As one skilled in the art will appreciate, manufacturers may refer to a component by different names. This document does not intend to distinguish between components that differ in name but not function. In the following description and in the claims, the terms "include" and "comprise" are used in an openended fashion, and thus should be interpreted to mean "include, but not limited to...". The term "substantially" means the value is within an acceptable error range. One skilled in the art can solve the technical problem within a predetermined error range and achieve the proposed technical performance. Also, the term "couple" is intended to mean either an indirect or direct electrical connection. Accordingly, if one device is coupled to another device, that connection may be through a direct electrical connection, or through an indirect electrical connection via other devices and connections.

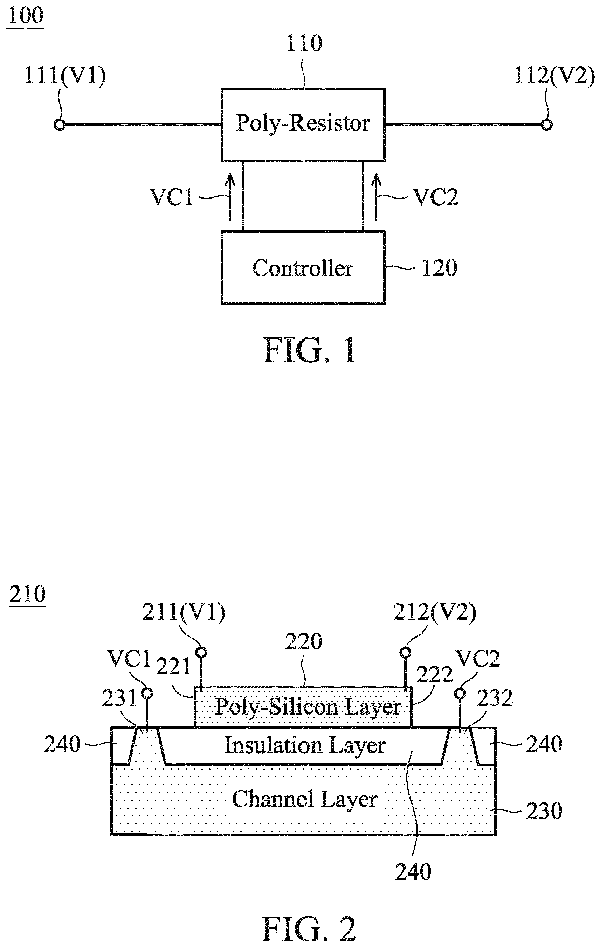

FIG. 1 is a diagram of an impedance circuit 100 according to an embodiment of the invention. The impedance circuit 100 includes a poly-resistor 110 and a controller 120. The poly-resistor 110 has a first terminal 111 and a second terminal 112. If a second voltage V2 at the second terminal 112 is higher than a first voltage V1 at the first terminal 111 (i.e., a driving voltage difference (V2-V1) is applied to the poly-resistor 110), a current through the poly-resistor 110 will flow from the second terminal 112 to the first terminal 111. The controller 120 may be a voltage generator, a voltage divider, or a weighted summer circuit. The controller 120 is configured to generate a first control voltage VC1 and a second control voltage VC2 for controlling the poly-resistor 110. The resistance between the first terminal 111 and the second terminal 112 of the poly-resistor 110 is determined according to the first control voltage VC1 and the second control voltage VC2. In one embodiment, the second control voltage VC2 is different from the first control voltage VC1.

Such a design can improve the linearity of the poly-resistor 110. Please refer to the following embodiments and figures. It should be noted that these embodiments and figures are exemplary, rather than restricted limitations of the invention.

FIG. 2 is a diagram of a poly-resistor 210 according to an embodiment of the invention. FIG. 2 illustrates the detailed physical structure of the poly-resistor 110 of FIG. 1. In FIG. 2, the poly-resistor 210 with a first terminal 211 and a second terminal 212 includes a poly-silicon layer 220, a channel layer 230 and an insulation layer 240. The poly-silicon layer 220 has a first end 221 and a second end 222, which are located apart from each other. The first end 221 of the poly-silicon layer 220 is coupled to the first terminal 211 of the poly-resistor 210, and the second end 222 of the poly-silicon layer 220 is coupled to the second terminal 212 of the poly-resistor 210. If a second voltage V2 at the second terminal 212 is higher than a first voltage V1 at the first terminal 211 (i.e., a driving voltage difference (V2-V1) is applied to the poly-resistor 210), a current through the poly-resistor 210 will flow from the second terminal 212 to the first terminal 211. That is, the current may flow through the poly-silicon layer 220, from the second end 222 to the first end 221. The channel layer 230 may be a conductive layer, a semiconductor layer, or another poly-silicon layer which is different from the poly-silicon layer 220. The channel layer 230 has a first end 231 and a second end 232, which are located apart from each other. The first end 231 of the channel layer 230 is arranged for receiving the first control voltage VC1, and the second end 232 of the channel layer 230 is arranged for receiving the second control voltage VC2. In some embodiments, the first end 231 of the channel layer 230 is closer to the first end 221 of the poly-silicon layer 220 than to the second end 232 of the channel layer 230, and the second end 232 of the channel layer 230 is closer to the second end 222 of the poly-silicon layer 220 than to the first end 231 of the channel layer 230. As a result, the first control voltage VC1 controls the operation characteristic (e.g., the resistance) of the first end 221 of the poly-silicon layer 220, and the second control voltage VC2 controls the operation characteristic (e.g., the resistance) of the second end 222 of the poly-silicon layer 220. The insulation layer 240 may be made of any nonconductive material. The insulation layer 240 is disposed between the poly-silicon layer 220 and the channel layer 230, and is configured to isolate the poly-silicon layer 220 from the channel layer 230.

Please refer to FIG. 1 further in view of FIG. 2 and understand the operation theory of the invention. To suppress the depletion effect of the poly-resistor 110, the first control voltage VC1 and the second control voltage VC2 may be dynamic, instead of being constant values. For example, the first control voltage VC1 and the second control voltage VC2 may be determined according to the first voltage V1 at the first terminal 111 of the poly-resistor 110, and the second voltage V2 at the second terminal 112 of the poly-resistor 110. That is, each of the first control voltage VC1 and the second control voltage VC2 may be a function of the first voltage V1 and the second voltage V2. The aforementioned functions may be linear and expressed as the following equations (1) to (3):

$$VC1 = f(V1, V2) = A \cdot V1 + B \cdot V2$$

$$\dots\dots\dots\dots\dots\dots\dots\dots\dots\dots\dots\dots\dots(1)$$

$$VC2 = g(V1, V2) = C \cdot V1 + D \cdot$$

$$V2\dots\dots\dots\dots\dots\dots\dots\dots\dots.\dots\dots\dots(2)$$

$$VC2 \neq VC1$$

$$\dots\dots\dots\dots\dots\dots\dots\dots\dots\dots\dots\dots\dots\dots\dots\dots\dots..(3)$$

where "VC1" represents the first control voltage VC1, "VC2" represents the second control voltage VC2, "V1" represents the first voltage V1, "V2" represents the second voltage V2, and each of "A", "B", "C", and "D" represents a respective value.

The above values A, B, C, and D are adjustable in response to different requirements. Specifically, when the controller 120 dynamically adjusts the first control voltage VC1 and the second control voltage VC2 in response to the first voltage V1 and the second voltage V2, the depletion effect of the poly-resistor 110 can be suppressed. The proposed impedance circuit is more linear and more concentrated than the conventional poly-resistor in which only one control voltage is applied to the poly-resistor, or the control voltage applied to the poly-resistor is fixed.

In some embodiments, the first control voltage VC1 is substantially equal to the first voltage V1, and the second control voltage VC2 is substantially equal to the second voltage V2. That is, according to the equations (1) to (3), the values A and D are both set to 1, and the values B and C are both set to 0. Please refer to the physical structure of FIG. 2. If the first control voltage VC1 is equal to the first voltage V1 and the second control voltage VC2 is equal to the second voltage V2, the control voltage difference (e.g., VC2-VC1) between the second control voltage VC2 and the first control voltage VC1 will be the same as the driving voltage difference (e.g.,V2-V1) between the second terminal 212 and the first terminal 211 of the poly-resistor 210. The control voltage difference (e.g., VC2-VC1) is uniformly distributed over the channel layer 230, and it is consistent with the driving voltage difference (e.g.,V2-V1) which is uniformly distributed over the poly-silicon layer 220. With such a design, the channel layer 230 has almost the same voltage level distribution as that of the poly-silicon layer 220, and no effective voltage difference exists between the channel layer 230 and the poly-silicon layer 220. Therefore, compared with the conventional method applying only one control voltage, the depletion effect of the poly-resistor 210 can be eliminated, and the poly-resistor 210 can provide resistance to accomplish better and more concentrated linearity.

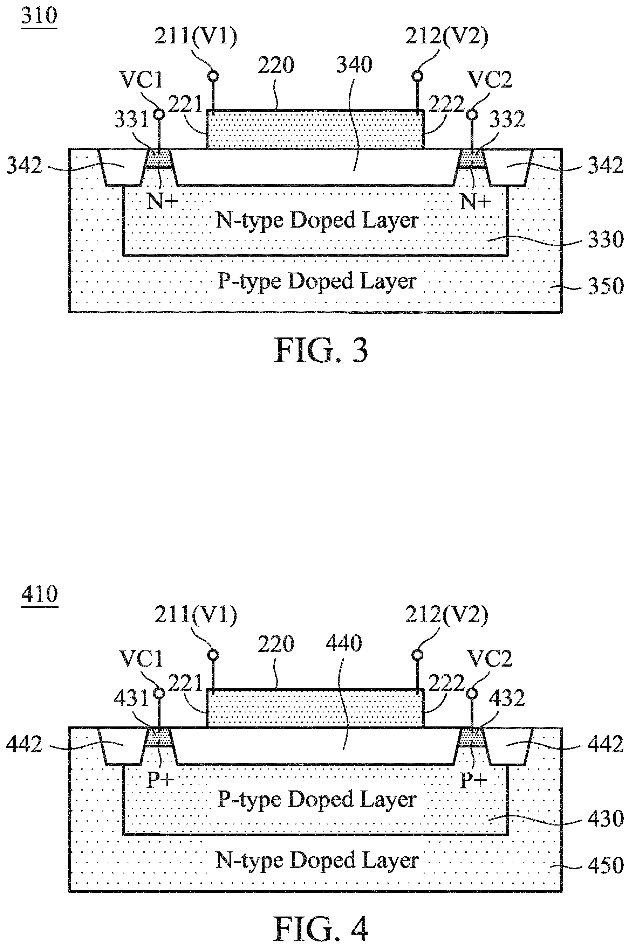

FIG. 3 is a diagram of a poly-resistor 310 according to an embodiment of the invention. FIG. 3 is similar to FIG. 2. In the embodiment of FIG. 3, a channel layer 330 of the poly-resistor 310 is an N-type doped layer, which may be configured in a P-type doped layer 350, and a first end 331 and a second end 332 of the channel layer 330 are n+ doped regions. An insulation layer 340 of the poly-resistor 310 can be of different materials, such as a silicon dioxide layer, a field oxide (FOX) layer, or a Shallow Trench Isolation (STI) layer, but is not limited thereto. Other features of the poly-resistor 310 of FIG. 3 are similar to those of the poly-resistor 210 of FIG. 2. FIG. 4 is a diagram of a poly-resistor 410 according to an embodiment of the invention. FIG. 4 is similar to FIG. 2. In the embodiment of FIG. 4, a channel layer 430 of the poly-resistor 410 is a P-type doped layer, which may be configured in an N-type doped layer 450, and a first end 431 and a second end 432 of the channel layer 430 are p+ doped regions. An insulation layer 440 can be of different materials, such as a silicon dioxide layer, a field oxide (FOX) layer, or a STI layer, but is not limited thereto. Other features of the poly-resistor 410 of FIG. 4 are similar to those of the poly-resistor 210 of FIG. 2.

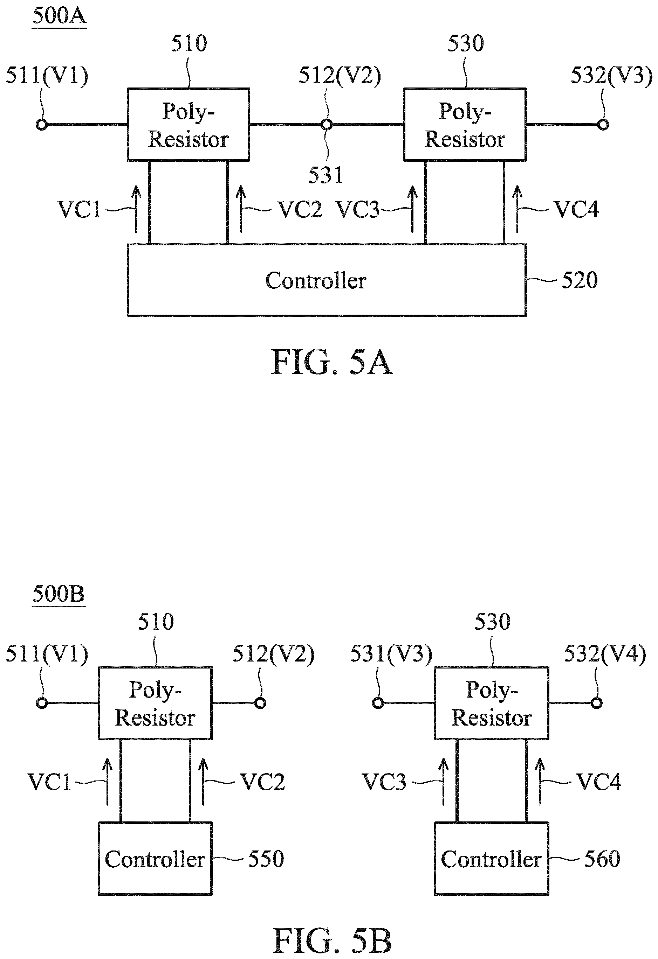

FIG. 5A is a diagram of an impedance circuit 500A according to an embodiment of the invention. FIG. 5A is similar to FIG. 1. In the embodiment of FIG. 5A, the impedance circuit 500A includes a first poly-resistor 510, a second poly-resistor 530, and a controller 520. The first poly-resistor 510 has a first terminal 511 and a second terminal 512. The second poly-resistor 530 has a first terminal 531 and a second terminal 532. The first terminal 531 of the second poly-resistor 530 is coupled to the second terminal 512 of the first poly-resistor 510. The controller 520 is configured to generate a first control voltage VC1, a second control voltage VC2, a third control voltage VC3, and a fourth control voltage VC4 for controlling the first poly-resistor 510 and the second poly-resistor 530. The resistance between the first terminal 511 and the second terminal 512 of the first poly-resistor 510 is determined according to the first control voltage VC1 and the second control voltage VC2. In one embodiment, the second control voltage VC2 is different from the first control voltage VC1. The resistance between the first terminal 531 and the second terminal 532 of the second poly-resistor 530 is determined according to the third control voltage VC3 and the fourth control voltage VC4. In one embodiment, the fourth control voltage VC4 is different from the third control voltage VC3.

In the impedance circuit 500A, a first poly-resistor 510 and a second poly-resistor 530 are coupled in series. The first control voltage VC1, the second control voltage VC2, the third control voltage VC3 and the fourth control voltage VC4 may be dynamic. The first control voltage VC1 and the second control voltage VC2 may be determined according to a first voltage V1 at the first terminal 511 of the first poly-resistor 510, and a second voltage V2 at the second terminal 512 of the first poly-resistor 510. Each of the first control voltage VC1 and the second control voltage VC2 may be a function of the first voltage V1 and the second voltage V2. The aforementioned function may be linear. For example, the first control voltage VC1 may be substantially equal to the first voltage V1, and the second control voltage VC2 may be substantially equal to the second voltage V2, but they are not limited thereto. The third control voltage VC3 and the fourth control voltage VC4 may be determined according to the second voltage V2 at the first terminal 531 of the second poly-resistor 530, and a third voltage V3 at the second terminal 532 of the second poly-resistor 530. Each of the third control voltage VC3 and the fourth control voltage VC4 may be a function of the second voltage V2 and the third voltage V3. The aforementioned function may be linear. For example, the third control voltage VC3 may be substantially equal to the second voltage V2, and the fourth control voltage VC4 may be substantially equal to the third voltage V3, but they are not limited thereto. Other features of the impedance circuit 500A of FIG. 5A are similar to those of the impedance circuit 100 of FIG. 1. Accordingly, the two embodiments can achieve similar levels of performance. It should be noted that the impedance circuit 500A may include three or more poly-resistors which are coupled in series and controlled by the controller in a similar way although there are only two poly-resistors displayed in FIG. 5A.

FIG. 5B is a diagram of an impedance circuit 500B according to another embodiment of the invention. FIG. 5B is similar to FIG. 5A. In the embodiment of FIG. 5B, the impedance circuit 500B further includes a first controller 550 and a second controller 560. Such a design can also suppress the non-linear depletion effect. The first controller 550 is configured to generate the first control voltage VC1 and the second control voltage VC2 for controlling the first poly-resistor 510. The second controller 560 is configured to generate the third control voltage VC3 and the fourth control voltage VC4 for controlling the second poly-resistor 530. Similarly, the first control voltage VC1, the second control voltage VC2, the third control voltage VC3, and the fourth control voltage VC4 may be dynamic. In the impedance circuit 500B, the second poly-resistor 530 is separate from the first poly-resistor 510. The first control voltage VC1 and the second control voltage VC2 may be determined according to a first voltage V1 at the first terminal 511 of the first poly-resistor 510, and a second voltage V2 at the second terminal 512 of the first poly-resistor 510. Each of the first control voltage VC1 and the second control voltage VC2 may be a function of the first voltage V1 and the second voltage V2. The aforementioned function may be linear. For example, the first control voltage VC1 may be substantially equal to the first voltage V1, and the second control voltage VC2 may be substantially equal to the second voltage V2, but they are not limited thereto. The third control voltage VC3 and the fourth control voltage VC4 may be determined according to a third voltage V3 at the first terminal 531 of the second poly-resistor 530, and a fourth voltage V4 at the second terminal 532 of the second poly-resistor 530. Each of the third control voltage VC3 and the fourth control voltage VC4 may be a function of the third voltage V3 and the fourth voltage V4. The aforementioned function may be linear. For example, the third control voltage VC3 may be substantially equal to the third voltage V3, and the fourth control voltage VC4 may be substantially equal to the fourth voltage V4, but they are not limited thereto. Other features of the impedance circuit 500B of FIG. 5B are similar to those of the impedance circuit 500A of FIG. 5A. It should be noted that the impedance circuit 500B may include three or even more poly-resistors which are respectively controlled by three or more controllers in a similar way.

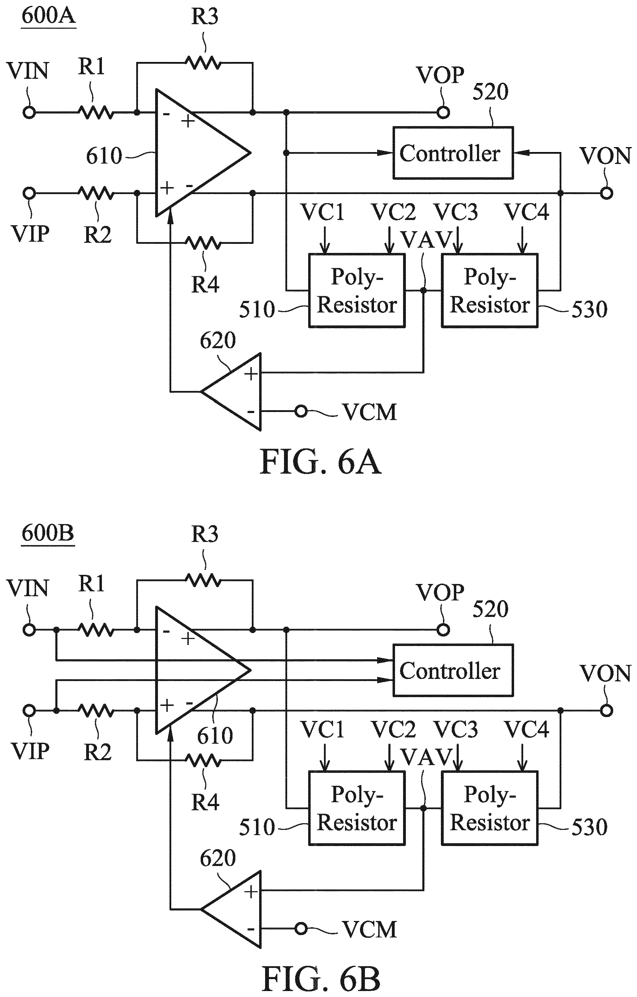

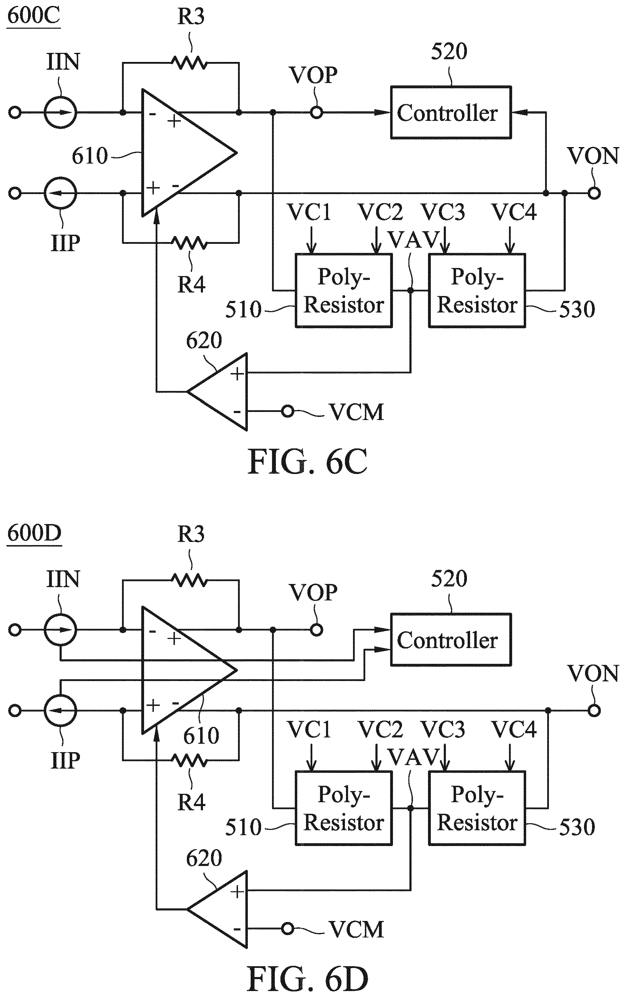

The proposed impedance circuit and the poly-resistor therein can be applied to a variety of circuits. Please refer to the following embodiments in FIGS. 6-8.

FIG. 6A is a diagram of a differential or pseudo-differential amplifier 600A according to an embodiment of the invention. In the embodiment of FIG. 6A, the differential or pseudo-differential amplifier 600A generates a positive output voltage VOP and a negative output voltage VON according to a positive input voltage VIP and a negative input voltage VIN. For example, the positive output voltage VOP and the negative output voltage VON may have different electrical characteristic, such as different current driving capabilities, different output signal swings, or different frequency responses. Specifically, the differential or pseudo-differential amplifier 600A includes a main operational amplifier 610, an auxiliary operational amplifier 620, a first resistor R1, a second resistor R2, a third resistor R3, a fourth resistor R4, a controller 520, a first poly-resistor 510, and a second poly-resistor 530. The first resistor R1 is coupled between the negative input voltage VIN and a negative input terminal of the main operational amplifier 610. The second resistor R2 is coupled between the positive input voltage VIP and a positive input terminal of the main operational amplifier 610. The third resistor R3 is coupled between the negative input terminal and a positive output terminal (i.e., the positive output voltage VOP) of the main operational amplifier 610. The fourth resistor R4 is coupled between the positive input terminal and a negative output terminal (i.e., the negative output voltage VON) of the main operational amplifier 610. An inner voltage VAV is between the first poly-resistor 510 and the second resistor 530, and it may be close to a common voltage VCM. The first poly-resistor 510 is coupled between the positive output terminal (i.e., the positive output voltage VOP) of the main operational amplifier 610 and the inner voltage VAV. The second poly-resistor 530 is coupled between the inner voltage VAV and the negative output terminal (i.e., the negative output voltage VON) of the main operational amplifier 610. The auxiliary operational amplifier 620 compares the inner voltage VAV with the common voltage VCM, so as to adjust the output common-mode voltage (VCMO) of the main operational amplifier 610 with a negative feedback mechanism. The common voltage VCM may be set to a ground voltage VSS (e.g., 0V). The controller 520 is configured to generate a first control voltage VC1 and a second control voltage VC2 for controlling the first poly-resistor 510, and further generate a third control voltage VC3 and a fourth control voltage VC4 for controlling the second poly-resistor 530. In some embodiments, the first control voltage VC1, the second control voltage VC2, the third control voltage VC3, and the fourth control voltage VC4 are determined according to the positive output voltage VOP, the negative output voltage VON, and the inner voltage VAV. Specifically, each of the first control signal VC1 and the second control signal VC2 may be dynamic and be a function of the positive output voltage VOP and the inner voltage VAV; and each of the third control signal VC3 and the fourth control signal VC4 may be dynamic and be a function of the inner voltage VAV and the negative output voltage VON. For example, the first control voltage VC1 may be substantially equal to the positive output voltage VOP, the second control voltage VC2 and the third control voltage VC3 may be both substantially equal to the inner voltage VAV, and the fourth control voltage VC4 may be substantially equal to the negative output voltage VON, but they are not limited thereto. In the embodiment of FIG. 6A, each of the first poly-resistor 510 and the second poly-resistor 530 is a common-mode feedback resistor used in the differential or pseudo-differential amplifier 600A.

FIG. 6B is a diagram of a differential or pseudo-differential amplifier 600B according to an embodiment not covered by the claims. FIG. 6B is similar to FIG. 6A. In the embodiment of FIG. 6B, the controller 520 controls the first poly-resistor 510 and the second resistor 530 according to the positive input voltage VIP and the negative input voltage VIN, which are related to the positive output voltage VOP and the negative output voltage VON. FIG. 6C is a diagram of a differential or pseudo-differential amplifier 600C according to an embodiment of the invention. FIG. 6C is similar to FIG. 6A. In the embodiment of FIG. 6C, the differential or pseudo-differential amplifier 600C generates the positive output voltage VOP and the negative output voltage VON according to a positive input current IIP and a negative input current IIN. FIG. 6D is a diagram of a differential or pseudo-differential amplifier 600D according to an embodiment of the invention. FIG. 6D is similar to FIG. 6C. In the embodiment of FIG. 6D, the controller 520 controls the first poly-resistor 510 and the second resistor 530 according to the positive input current IIP and the negative input current IIN, which are related to the positive output voltage VOP and the negative output voltage VON. Other features of the differential or pseudo-differential amplifiers 600B, 600C, and 600D of FIGS. 6B, 6C, and 6D are similar to those of the differential or pseudo-differential amplifier 600A of FIG. 6A. Accordingly, these embodiments can achieve similar levels of performance.

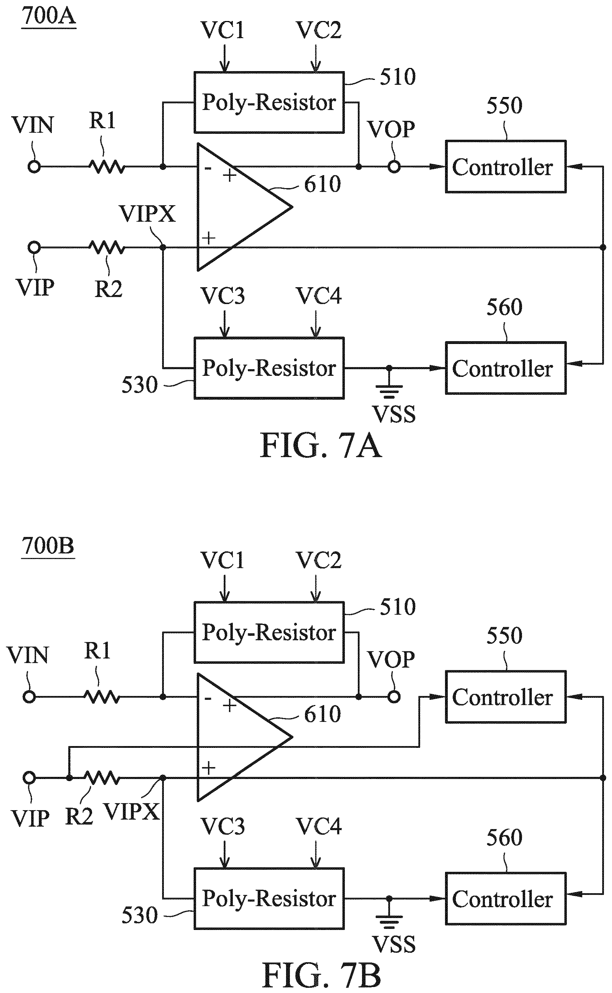

FIG. 7A is a diagram of a differential-to-single-ended amplifier 700A according to an embodiment not covered by the claims. In the embodiment of FIG. 7A, the differential-to-single-ended amplifier 700A generates a positive output voltage VOP according to a positive input voltage VIP and a negative input voltage VIN. Specifically, the differential-to-single-ended amplifier 700A includes a main operational amplifier 610, a first resistor R1, a second resistor R2, a first poly-resistor 510, a second poly-resistor 530, a first controller 550, and a second controller 560. The first resistor R1 is coupled between the negative input voltage VIN and a negative input terminal of the main operational amplifier 610. The second resistor R2 is coupled between the positive input voltage VIP and a positive input terminal of the main operational amplifier 610. A positive inner voltage VIPX is at the positive input terminal of the main operational amplifier 610. The first poly-resistor 510 is coupled between the negative input terminal and a positive output terminal (i.e., the positive output voltage VOP) of the main operational amplifier 610. The second poly-resistor 530 is coupled between the positive input terminal of the main operational amplifier 610 and a ground voltage VSS. The first controller 550 is configured to generate a first control voltage VC1 and a second control voltage VC2 for controlling the first poly-resistor 510. The second controller 560 is configured to generate a third control voltage VC3 and a fourth control voltage VC4 for controlling the second poly-resistor 530. In some embodiments, the first control voltage VC1, the second control voltage VC2, the third control voltage VC3, and the fourth control voltage VC4 are determined according to the positive output voltage VOP, the positive inner voltage VIPX, and the ground voltage VSS. Specifically, each of the first control signal VC1 and the second control signal VC2 may be dynamic and be a function of the positive inner voltage VIPX and the positive output voltage VOP; and each of the third control signal VC3 and the fourth control signal VC4 may be dynamic and be a function of the positive inner voltage VIPX and the ground voltage VSS. For example, the first control voltage VC1 and the third control voltage VC3 may be substantially equal to the positive inner voltage VIPX, the second control voltage VC2 may be substantially equal to the positive output voltage VOP, and the fourth control voltage VC4 may be substantially equal to the ground voltage VSS, but they are not limited thereto. In the embodiment of FIG. 7A, each of the first poly-resistor 510 and the second poly-resistor 530 is a feedback resistor used in the differential-to-single-ended amplifier 700A.

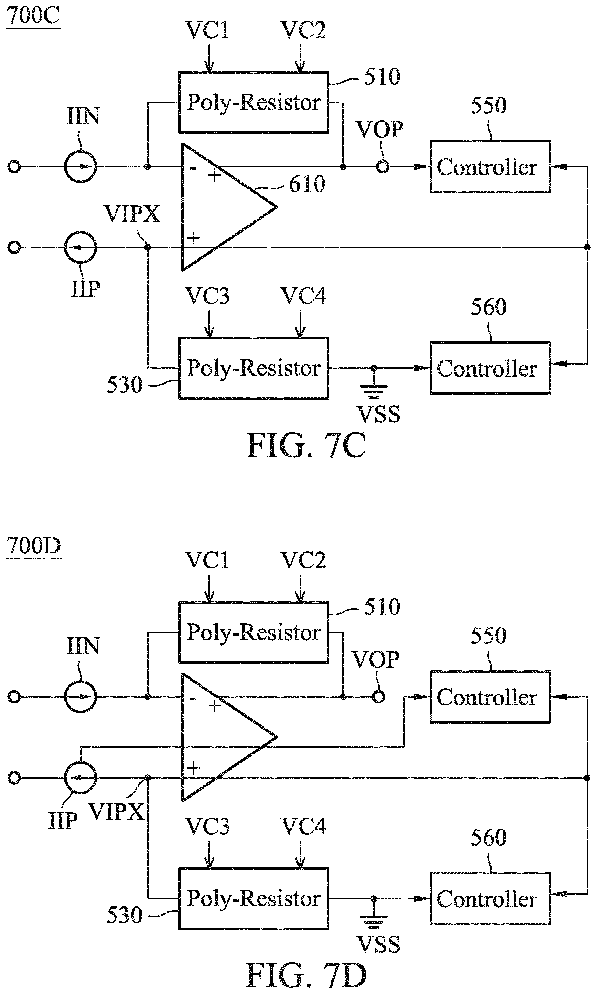

FIG. 7B is a diagram of a differential-to-single-ended amplifier 700B according to an embodiment not covered by the claims. FIG. 7B is similar to FIG. 7A. In the embodiment of FIG. 7B, the first controller 550 controls the first poly-resistor 510 according to the positive input voltage VIP, which is related to the positive output voltage VOP. FIG. 7C is a diagram of a differential-to-single-ended amplifier 700C according to an embodiment of the invention. FIG. 7C is similar to FIG. 7A. In the embodiment of FIG. 7C, the differential-to-single-ended amplifier 700C generates the positive output voltage VOP according to a positive input current IIP and a negative input current IIN FIG. 7D is a diagram of a differential-to-single-ended amplifier 700D according to an embodiment of the invention. FIG. 7D is similar to FIG. 7C. In the embodiment of FIG. 7D, the first controller 550 controls the first poly-resistor 510 according to the positive input current IIP, which is related to the positive output voltage VOP. Other features of the differential-to-single-ended amplifiers 700B, 700C, and 700D of FIGS. 7B, 7C, and 7D are similar to those of the differential-to-single-ended amplifier 700A of FIG. 7A. Accordingly, these embodiments can achieve similar levels of performance.

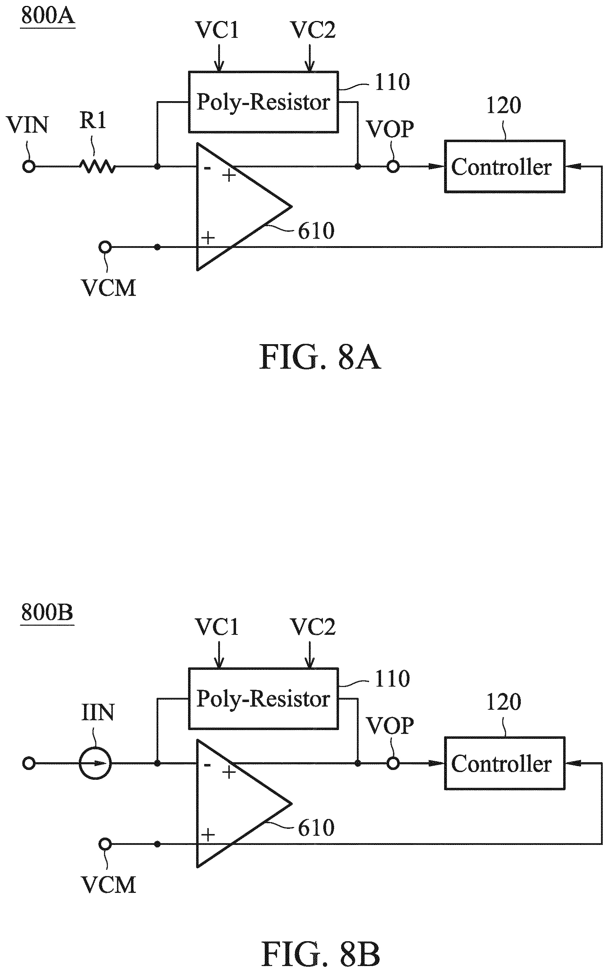

FIG. 8A is a diagram of an inverting amplifier 800A according to an embodiment not covered by the claims. In the embodiment of FIG. 8A, the inverting amplifier 800A generates a positive output voltage VOP according to a negative input voltage VIN. Specifically, the inverting amplifier 800A includes a main operational amplifier 610, a first resistor R1, a controller 120, and a poly-resistor 110. The first resistor R1 is coupled between the negative input voltage VIN and a negative input terminal of the main operational amplifier 610. A common voltage VCM is at a positive input terminal of the main operational amplifier 610. The common voltage VCM may be set to a ground voltage VSS (e.g., 0V). The poly-resistor 110 is coupled between the negative input terminal and a positive output terminal (i.e., the positive output voltage VOP) of the main operational amplifier 610. The controller 120 is configured to generate a first control voltage VC1 and a second control voltage VC2 for controlling the poly-resistor 110. In some embodiments, the first control voltage VC1 and the second control voltage VC2 are determined according to the positive output voltage VOP and the common voltage VCM. Specifically, each of the first control signal VC1 and the second control signal VC2 may be dynamic and be a function of the positive output voltage VOP and the common voltage VCM. For example, the first control voltage VC1 may be substantially equal to the common voltage VCM, and the second control voltage VC2 may be substantially equal to the positive output voltage VOP, but they are not limited thereto. In the embodiment of FIG. 8A, the poly-resistor 110 is a feedback resistor used in the inverting amplifier 800A.

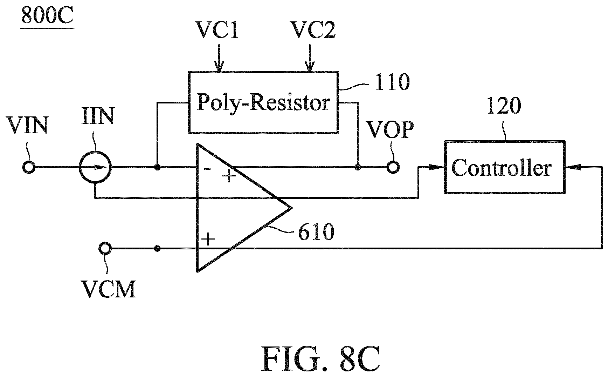

FIG. 8B is a diagram of an inverting amplifier 800B according to an embodiment not covered by the claims. FIG. 8B is similar to FIG. 8A. In the embodiment of FIG. 8B, the inverting amplifier 800B generates the positive output voltage VOP according to a negative input current IIN. FIG. 8C is a diagram of an inverting amplifier 800C according to an embodiment of the invention. FIG. 8C is similar to FIG. 8B. In the embodiment of FIG. 8C, the controller 120 controls the poly-resistor 110 according to the positive input current IIN, which is related to the positive output voltage VOP. Other features of the inverting amplifiers 800B and 800C of FIGS. 8B and FIG. 8C are similar to those of the inverting amplifier 800A of FIG. 8A. Accordingly, these embodiments can achieve similar levels of performance.

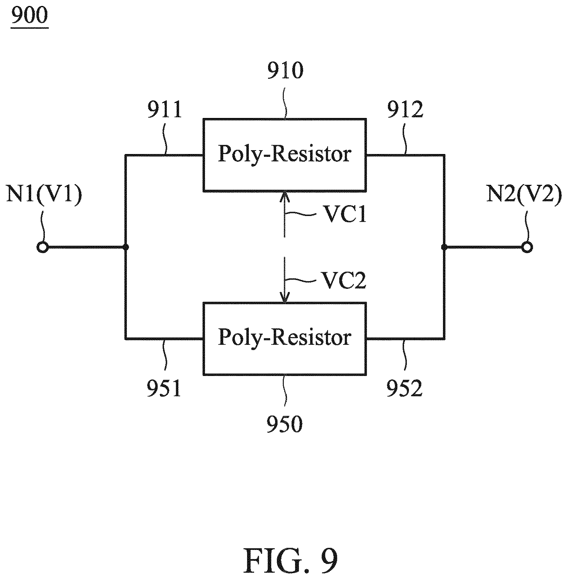

FIG. 9 is a diagram of an impedance circuit 900 according to another embodiment of the invention. The impedance circuit 900 includes a first poly-resistor 910 and a second poly-resistor 950. In some embodiments, the first poly-resistor 910 and the second poly-resistor 950 have identical structures. In alternative embodiments, the first poly-resistor 910 and the second poly-resistor 950 have different structures but the same resistances. The first poly-resistor 910 has a first terminal 911 and a second terminal 912. The second poly-resistor 950 has a first terminal 951 and a second terminal 952. The first poly-resistor 910 and the second poly-resistor 950 are coupled in parallel. Specifically, the first terminal 911 of the first poly-resistor 910 and the first terminal 951 of the second poly-resistor 950 are both coupled to a first node N1; the second terminal 912 of the first poly-resistor 910 and the second terminal 952 of the second poly-resistor 950 are both coupled to a second node N2. The first node N1 and the second node N2 may be considered as I/O (Input/Output) nodes of the impedance circuit 900. If a second voltage V2 at the second node N2 is higher than a first voltage V1 at the first node N1 (i.e., a driving voltage difference (V2-V1) is applied to the impedance circuit 900), a current through the first poly-resistor 910 and the second poly-resistor 950 will flow from the second node N2 to the first node N1. The resistance between the first terminal 911 and the second terminal 912 of the first poly-resistor 910 is determined according to a first control voltage VC1. The resistance between the first terminal 951 and the second terminal 952 of the second poly-resistor 950 is determined according to a second control voltage VC2. In one embodiment, the second control voltage VC2 is different from the first control voltage VC1. The first control voltage VC1 and the second control voltage VC2 are determined according to the first voltage V1 at the first node N1 and the second voltage V2 at the second node N2.

In some embodiments, the first control voltage VC1 and the second control voltage VC2 are generated by a controller (not shown), but they are not limited thereto. The controller may be a voltage generator, a voltage divider, or a weighted summer circuit. In alternative embodiments, any of the first control voltage VC1 and the second control voltage VC2 is tied together with the first voltage V1 or the second voltage V2, and no controller is required.

With respect to the operation theory, the first poly-resistor 910 may induce a positive depletion effect or a positive resistance variation, and the second poly-resistor 950 may induce a negative depletion effect or a negative resistance variation. When the first poly-resistor 910 and the second poly-resistor 950 are coupled in parallel, the positive depletion effect will be cancelled by the negative depletion effect. Accordingly, such a design can improve the linearity of the impedance circuit 900. Please refer to the following embodiments and figures. It should be noted that these embodiments and figures are exemplary, rather than restricted limitations of the invention.

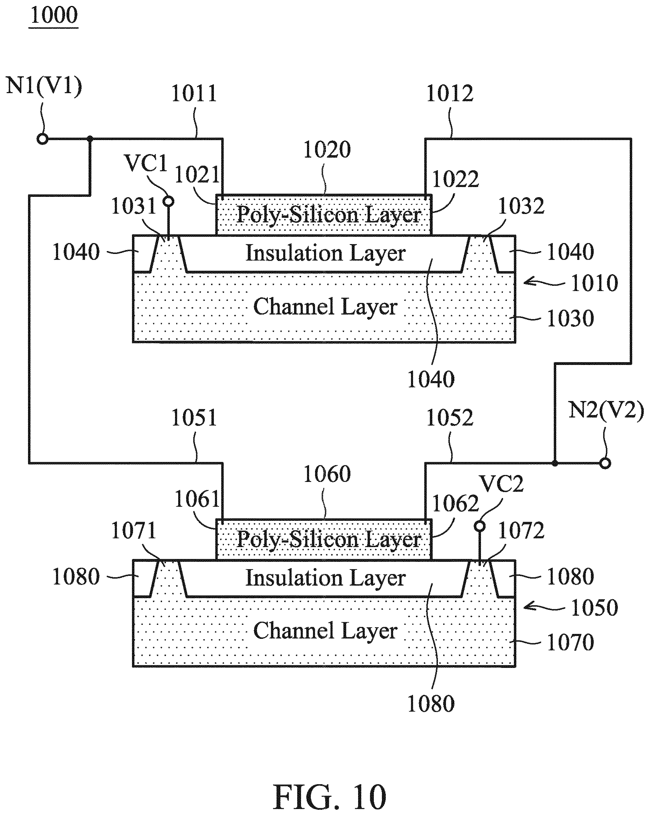

FIG. 10 is a diagram of an impedance circuit 1000 according to another embodiment of the invention. FIG. 10 illustrates the detailed physical structure of the impedance circuit 900 of FIG. 9. The impedance circuit 1000 includes a first poly-resistor 1010 and a second poly-resistor 1050, which are coupled in parallel. In some embodiments, the first poly-resistor 1010 and the second poly-resistor 1050 have identical structures. In alternative embodiments, the first poly-resistor 1010 and the second poly-resistor 1050 have different structures but the same resistances. As shown in FIG. 10, the first poly-resistor 1010 with a first terminal 1011 and a second terminal 1012 includes a first poly-silicon layer 1020, a first channel layer 1030, and a first insulation layer 1040. The first poly-silicon layer 1020 has a first end 1021 and a second end 1022, which are located apart from each other. The first end 1021 of the first poly-silicon layer 1020 is coupled to a first node N1 (i.e., the first terminal 1011 of the first poly-resistor 1010). The second end 1022 of the first poly-silicon layer 1020 is coupled to a second node N2 (i.e., the second terminal 1012 of the first poly-resistor 1010). The first channel layer 1030 may be a conductive layer, a semiconductor layer, or another poly-silicon layer which is different from the first poly-silicon layer 1020. The first channel layer 1030 can have has a first end 1031 and a second end 1032, which are located apart from each other. The first end 1031 of the first channel layer 1030 is arranged for receiving a first control voltage VC1. In some embodiments, the first end 1031 of the first channel layer 1030 is closer to the first end 1021 of the first poly-silicon layer 1020 than to the second end 1032 of the first channel layer 1030; the second end 1032 of the first channel layer 1030 is closer to the second end 1022 of the first poly-silicon layer 1020 than to the first end 1031 of the first channel layer 1030. The first insulation layer 1040 may be made of any nonconductive material. The first insulation layer 1040 is disposed between the first poly-silicon layer 1020 and the first channel layer 1030, and is configured to isolate the first poly-silicon layer 1020 from the first channel layer 1030.

Similarly, the second poly-resistor 1050 with a first terminal 1051 and a second terminal 1052 includes a second poly-silicon layer 1060, a second channel layer 1070, and a second insulation layer 1080. The second poly-silicon layer 1060 has a first end 1061 and a second end 1062, which are located apart from each other. The first end 1061 of the second poly-silicon layer 1060 is coupled to the first node N1 (i.e., the first terminal 1051 of the second poly-resistor 1050). The second end 1062 of the second poly-silicon layer 1060 is coupled to the second node N2 (i.e., the second terminal 1052 of the second poly-resistor 1050). The second channel layer 1070 may be a conductive layer, a semiconductor layer, or another poly-silicon layer which is different from the second poly-silicon layer 1060. The second channel layer 1070 has a first end 1071 and a second end 1072, which are located apart from each other. The second end 1072 of the second channel layer 1070 is arranged for receiving a second control voltage VC2. In some embodiments, the first end 1071 of the second channel layer 1070 is closer to the first end 1061 of the second poly-silicon layer 1060 than to the second end 1072 of the second channel layer 1070; the second end 1072 of the second channel layer 1070 is closer to the second end 1062 of the second poly-silicon layer 1060 than to the first end 1071 of the second channel layer 1070. The second insulation layer 1080 may be made of any nonconductive material. The second insulation layer 1080 is disposed between the second poly-silicon layer 1060 and the second channel layer 1070, and is configured to isolate the second poly-silicon layer 1060 from the second channel layer 1070.

In some embodiments, each of the first poly-resistor 1010 and the second poly-resistor 1050 includes the same doped layers and doped regions as described in FIG. 3 and FIG. 4. As mentioned above, each of the first insulation layer 1040 and the second insulation layer 1080 may be a silicon dioxide layer, a field oxide (FOX) layer, or a shallow trench isolation (STI) layer.

If a second voltage V2 at the second node N2 is higher than a first voltage V1 at the first node N1 (i.e., a driving voltage difference (V2-V1) is applied to the impedance circuit 1000), a current through the first poly-resistor 1010 and the second poly-resistor 1050 will flow from the second node N2 to the first node N1. The current may flow through the first poly-silicon layer 1020, from the second end 1022 to the first end 1021. Also, the current may flow through the second poly-silicon layer 1060, from the second end 1062 to the first end 1061. As a result, the first control voltage VC1 controls the operation characteristic (e.g., the resistance) of the first poly-silicon layer 1020, and the second control voltage VC2 controls the operation characteristic (e.g., the resistance) of the second poly-silicon layer 1060.

Please refer to FIG. 9 further in view of FIG. 10 and understand the operation theory of the invention. To suppress the depletion effect of the first poly-resistor 910 and the second poly-resistor 950, besides the parallel connection of poly-resistors, the first control voltage VC1 and the second control voltage VC2 should be determined according to the first voltage V1 at the first node N1 and the second voltage V2 at the second node N2. That is, each of the first control voltage VC1 and the second control voltage VC2 may be a function of the first voltage V1 and the second voltage V2. The aforementioned functions may be linear and expressed as the following equations (4) and (5):

$$VC1 = h1(V1, V2) = E \cdot V1 + F \cdot V2$$

$$\dots\dots\dots\dots\dots\dots\dots\dots\dots(4)$$

$$VC2 = k1(V1, V2) = G \cdot V1 + H \cdot$$

$$V2 \dots\dots\dots\dots\dots\dots\dots\dots\dots(5)$$

where "VC1" represents the first control voltage VC1, "VC2" represents the second control voltage VC2, "V1" represents the first voltage V1, "V2" represents the second voltage V2, and each of "E", "F", "G", and "H" represents a respective value.

The above values E, F, G, and H are adjustable in response to different requirements. In some embodiments, the first control voltage VC1 is substantially equal to the first voltage V1, and the second control voltage VC2 is substantially equal to the second voltage V2. That is, according to the equations (4) and (5), the values E and H are both set to 1, and the values F and G are both set to 0. Please refer to the physical structure of FIG. 10. If the first control voltage VC1 is equal to the first voltage V1 and the second control voltage VC2 is equal to the second voltage V2, the (positive) depletion effect on the first poly-silicon layer 1020 will be cancelled by the (negative) depletion effect on the second poly-silicon layer 1060. With such a design, the (positive) resistance variation in the first poly-silicon layer 1020 can be cancelled by the (negative) resistance variation in the second poly-silicon layer 1060. Therefore, the depletion effect of the impedance circuit 900 can be eliminated, and the impedance circuit 900 can provide resistance to accomplish better and more concentrated linearity.

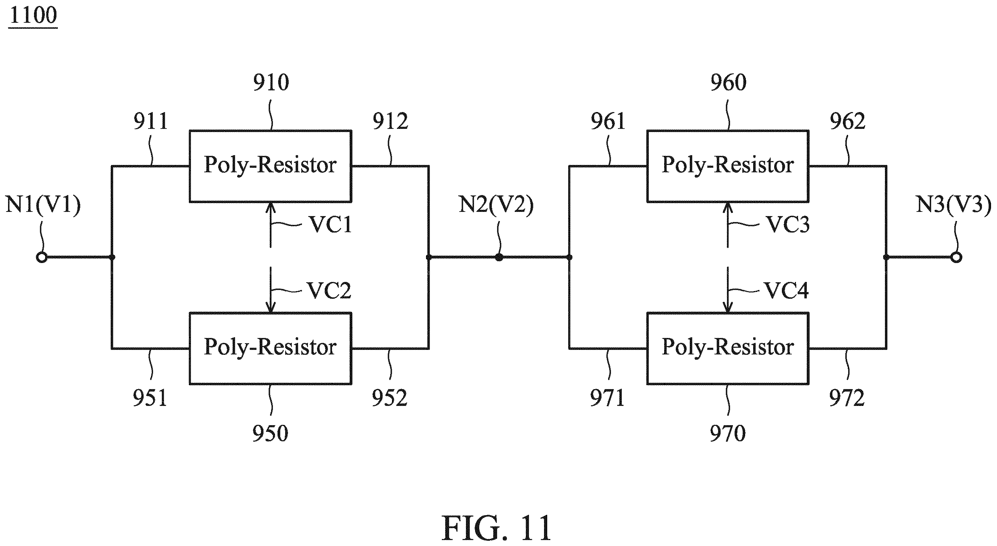

FIG. 11 is a diagram of an impedance circuit 1100 according to another embodiment of the invention. FIG. 11 is similar to FIG. 9. In the embodiment of FIG. 11, besides the first poly-resistor 910 and the second poly-resistor 950, the impedance circuit 1100 further includes a third poly-resistor 960 and a fourth poly-resistor 970. In some embodiments, the third poly-resistor 960 and the fourth poly-resistor 970 have identical structures. In alternative embodiments, the third poly-resistor 960 and the fourth poly-resistor 970 have different structures but the same resistances. The third poly-resistor 960 has a first terminal 961 and a second terminal 962. The fourth poly-resistor 970 has a first terminal 971 and a second terminal 972. The third poly-resistor 960 and the fourth poly-resistor 970 are coupled in parallel. Specifically, the first terminal 961 of the third poly-resistor 960 and the first terminal 971 of the fourth poly-resistor 970 are both coupled to the second node N2; the second terminal 962 of the third poly-resistor 960 and the second terminal 972 of the fourth poly-resistor 970 are both coupled to a third node N3. The first node N1 and the third node N3 may be considered as I/O (Input/Output) nodes of the impedance circuit 1100. If a third voltage V3 at the third node N3 is higher than a first voltage V1 at the first node N1 (i.e., a driving voltage difference (V3-V1) is applied to the impedance circuit 1100), a current through the first poly-resistor 910, the second poly-resistor 950, the third poly-resistor 960, and the fourth poly-resistor 970 will flow from the third node N3 to the first node N1. The resistance between the first terminal 961 and the second terminal 962 of the third poly-resistor 960 is determined according to a third control voltage VC3. The resistance between the first terminal 971 and the second terminal 972 of the fourth poly-resistor 970 is determined according to a fourth control voltage VC4. In one embodiment, the fourth control voltage VC4 is different from the third control voltage VC3. The third control voltage VC3 and the fourth control voltage VC4 are determined according to the second voltage V2 at the second node N2 and the third voltage V3 at the third node N3. In some embodiments, each of the first poly-resistor 910, the second poly resistor 950, the third poly-resistor 960, and the fourth poly-resistor 970 includes a similar physical structure to that described in the embodiment of FIG. 3, FIG. 4, or FIG. 10, and it will not be illustrated again here.

In some embodiments, each of the third control voltage VC3 and the fourth control voltage VC4 may be a function of the second voltage V2 and the third voltage V3. The aforementioned functions may be linear and expressed as the following equations (6) and (7):

$$VC3 = h2(V2, V3) = K \cdot V2 + L \cdot V3$$

$$\dots\dots\dots\dots\dots\dots\dots\dots\dots(6)$$

$$VC4 = k2(V2, V3) = M \cdot V2 + N \cdot$$

$$V3 \dots\dots\dots\dots\dots\dots\dots\dots\dots(7)$$

where "VC3" represents the third control voltage VC3, "VC4" represents the fourth control voltage VC4, "V2" represents the second voltage V2, "V3" represents the third voltage V3, and each of "K", "L", "M", and "N" represents a respective value.

The above values K, L, M, and N are adjustable in response to different requirements. In some embodiments, the third control voltage VC3 is substantially equal to the second voltage V2, and the fourth control voltage VC4 is substantially equal to the third voltage V3. That is, according to the equations (6) and (7), the values K and N are both set to 1, and the values L and M are both set to 0.

In alternative embodiments, each of the first control voltage V1, the second control voltage V2, the third control voltage VC3, and the fourth control voltage VC4 may be a linear function of the first voltage V1 and the third voltage V3. The third voltage V2 may be represented by a linear combination of the first voltage V1 and the third voltage V3. That is, for equations (4) and (5), each variable value "V2" may be replaced with another variable value "V3", which represents the third voltage V3; for equations (6) and (7), each variable value "V2" may be replaced with another variable value "V1", which represents the first voltage V1. Other features of the impedance circuit 1100 of FIG. 11 are similar to those of the impedance circuits 900 and 1000 of FIGS. 9 and 10. Accordingly, these embodiments can achieve similar levels of performance.

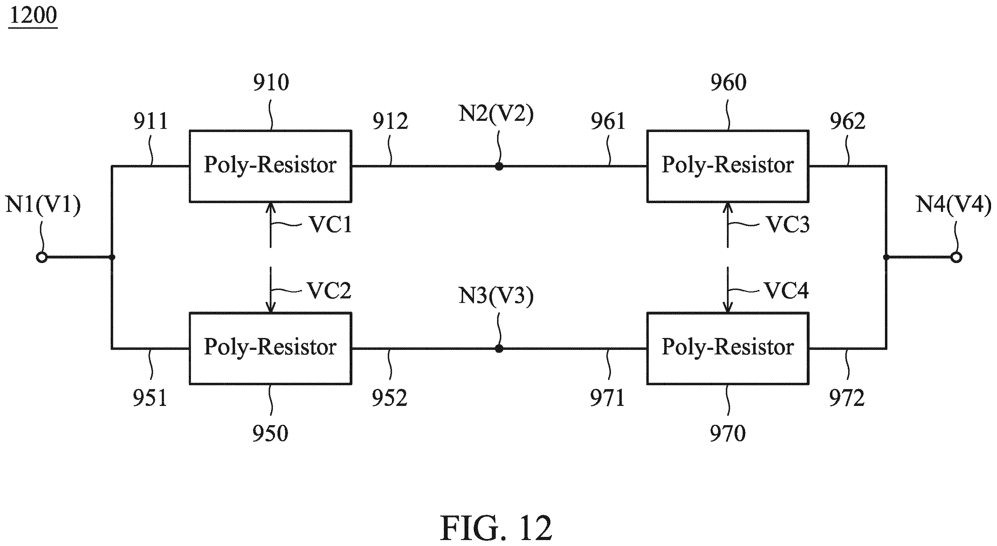

FIG. 12 is a diagram of an impedance circuit 1200 according to another embodiment of the invention. In the embodiment of FIG. 12, the impedance circuit 1200 includes a first poly-resistor 910, a second poly-resistor 950, a third poly-resistor 960, and a fourth poly-resistor 970. In some embodiments, the first poly-resistor 910, the second poly-resistor 950, the third poly-resistor 960, and the fourth poly-resistor 970 have identical structures. In alternative embodiments, the first poly-resistor 910, the second poly-resistor 950, the third poly-resistor 960, and the fourth poly-resistor 970 have different structures but the same resistances. The first poly-resistor 910 has a first terminal 911 and a second terminal 912. The second poly-resistor 950 has a first terminal 951 and a second terminal 952. The third poly-resistor 960 has a first terminal 961 and a second terminal 962. The fourth poly-resistor 970 has a first terminal 971 and a second terminal 972. The first poly-resistor 910 and the third poly-resistor 960 are coupled in series. The second poly-resistor 950 and the fourth poly-resistor 970 are coupled in series. A cascading combination of the first poly-resistor 910 and the third poly-resistor 960 are coupled in parallel with another cascading combination of the second poly-resistor 950 and the fourth poly-resistor 970. Specifically, the first terminal 911 of the first poly-resistor 910 and the first terminal 951 of the second poly-resistor 950 are both coupled to a first node N1; the second terminal 912 of the first poly-resistor 910 and the first terminal 961 of the third poly-resistor 960 are both coupled to a second node N2; the second terminal 952 of the second poly-resistor 950 and the first terminal 971 of the fourth poly-resistor 970 are both coupled to a third node N3; the second terminal 962 of the third poly-resistor 960 and the second terminal 972 of the fourth poly-resistor 970 are both coupled to a fourth node N4. The first node N1 and the fourth node N4 may be considered as I/O (Input/Output) nodes of the impedance circuit 1200. If a fourth voltage V4 at the fourth node N4 is higher than a first voltage V1 at the first node N1 (i.e., a driving voltage difference (V4-V1) is applied to the impedance circuit 1200), a current through the first poly-resistor 910, the second poly-resistor 950, the third poly-resistor 960, and the fourth poly-resistor 970 will flow from the fourth node N4 to the first node N1. The resistance between the first terminal 911 and the second terminal 912 of the first poly-resistor 910 is determined according to a first control voltage VC1. The resistance between the first terminal 951 and the second terminal 952 of the second poly-resistor 950 is determined according to a second control voltage VC2. The resistance between the first terminal 961 and the second terminal 962 of the third poly-resistor 960 is determined according to a third control voltage VC3. The resistance between the first terminal 971 and the second terminal 972 of the fourth poly-resistor 970 is determined according to a fourth control voltage VC4. In one embodiment, the first control voltage VC1, the second control voltage VC2, the third control voltage VC3, and the fourth control voltage VC4 are different from each other. In some embodiments, each of the first poly-resistor 910, the second poly resistor 950, the third poly-resistor 960, and the fourth poly-resistor 970 includes a similar structure to that described in the embodiment of FIG. 3, FIG. 4, or FIG. 10, and it will not be illustrated again here.

In some embodiments, each of the first control voltage VC1, the second control voltage VC2, the third control voltage VC3, and the fourth control voltage VC4 is a function of the first voltage V1 at the first node N1, the second voltage V2 at the second node N2, the third voltage V3 at the third node N3, and the fourth voltage V4 at the fourth node N4. The aforementioned functions may be linear and expressed as the following equations (8) to (11):

$$VC1 = h3(V1, V2, V3, V4) = A1 \cdot V1 + B1 \cdot V2 + C1 \cdot V3 + D1 \cdot V4 \ldots\ldots\ldots (8)$$

$$VC2 = k3(V1, V2, V3, V4) = A2 \cdot V1 + B2 \cdot V2 + C2 \cdot V3 + D2 \cdot V4 \ldots\ldots(9)$$

$$VC3 = h4(V1, V2, V3, V4) = A3 \cdot V1 + B3 \cdot V2 + C3 \cdot V3 + D3 \cdot V4 \ldots\ldots(10)$$

$$VC4 = k4(V1, V2, V3, V4) = A4 \cdot V1 + B4 \cdot V2 + C4 \cdot V3 + D4 \cdot V4 \ldots\ldots(11)$$

where "VC1" represents the first control voltage VC1, "VC2" represents the second control voltage VC2, "VC3" represents the third control voltage VC3, "VC4" represents the fourth control voltage VC4, "V1" represents the first voltage V1, "V2" represents the second voltage V2, "V3" represents the third voltage V3, "V4" represents the fourth voltage V4, and each of "A1", "A2", "A3", "A4", "B1", "B2", "B3", B4", "C1", "C2", "C3", "C4", "D1", "D2", "D3", and "D4" represents a respective value.

In some embodiments, the first control voltage VC1, the second control voltage VC2, the third control voltage VC3, and the fourth control voltage VC4 are generated and determined by a controller (not shown) according to the first voltage V1, the second voltage V2, the third voltage V3, and the fourth voltage V4, but they are not limited thereto. In alternative embodiments, any of the first control voltage VC1, the second control voltage VC2, the third control voltage VC3, and the fourth control voltage VC4 is tied together with the first voltage V1, the second voltage V2, the third voltage V3, or the fourth voltage V4, and no controller is required.

The above values A1, A2, A3, A4, B1, B2, B3, B4, C1, C2, C3, C4, D1, D2, D3, and D4 are adjustable in response to different requirements. In some embodiments, the first control voltage VC1 is substantially equal to the first voltage V1, the second control voltage VC2 is substantially equal to the third voltage V3, the third control voltage VC3 is substantially equal to the second voltage V2, and the fourth control voltage VC4 is substantially equal to the fourth voltage V4. Adjustments may be made such that the first control voltage VC1 is substantially equal to the second voltage V2, the second control voltage VC2 is substantially equal to the first voltage V1, the third control voltage VC3 is substantially equal to the fourth voltage V4, and the fourth control voltage VC4 is substantially equal to the third voltage V3. In alternative embodiments, the first control voltage VC1, the second control voltage VC2, the third control voltage VC3, and the fourth control voltage VC4 depend on only the first voltage V1 and the fourth voltage V4. That is, the values B1, B2, B3, B4, C1, C2, C3, and C4 are all set to 0. Other features of the impedance circuit 1200 of FIG. 12 are similar to those of the impedance circuits 900 and 1000 of FIGS. 9 and 10. Accordingly, these embodiments can achieve similar levels of performance.

It should be understood that the proposed impedance circuits 900, 1000, 1100, and 1200 can be applied to a variety of circuits as described in the embodiments of FIGS. 6-8. That is, each poly-resistor shown in the embodiments of FIGS. 6-8 may be replaced with a respective impedance circuit 900, 1000, 1100, or 1200.

The invention proposes a novel impedance circuit and poly-resistors coupled in parallel therein. Such a design can cancel the non-ideal depletion effect of the poly resistors. Alternatively, each poly-resistor may be further divided into a plurality of sub-poly-resistors coupled in series, without affecting the performance of the proposed impedance circuit. To be brief, the proposed impedance circuit can eliminate the depletion effect of the poly-resistors, and make the poly-resistors be more linear and subject to Ohm's law.

Note that the above voltages, currents, resistances, inductances, capacitances and other element parameters are not limitations of the invention. A designer can adjust these parameters according to different requirements. The impedance circuit and poly-resistors of the invention are not limited to the configurations of FIGS. 1-12. The invention may merely include any one or more features of any one or more embodiments of FIGS. 1-12. In other words, not all of the features displayed in the figures should be implemented in the impedance circuit and poly-resistors of the invention.

Use of ordinal terms such as "first", "second", "third", etc., in the claims to modify a claim element does not by itself connote any priority, precedence, or order of one claim element over another or the temporal order in which acts of a method are performed, but are used merely as labels to distinguish one claim element having a certain name from another element having the same name (but for use of the ordinal term) to distinguish the claim elements.

While the invention has been described by way of example and in terms of the preferred embodiments, it should be understood that the invention is defined by the appended claims.

## Claims

1. A differential or pseudo-differential amplifier (600A, 600B, 600C, 600D), comprising:

   a main operational amplifier (610);

   a first resistor (R3) coupled between a negative input terminal and a positive output terminal (VOP) of the main operational amplifier (610);
   a second resistor (R4) coupled between a positive input terminal and a negative output terminal (VON) of the main operational amplifier (610);

   a first poly-resistor (510);
   a second poly-resistor (530), wherein an inner voltage (VAV) is between the first poly-resistor (510) and the second poly-resistor (530), wherein the first poly-resistor (510) is coupled between the positive output terminal (VOP) of the main operational amplifier (610) and the inner voltage (VAV), wherein the second poly-resistor (530) is coupled between the inner voltage (VAV) and the negative output terminal (VON) of the main operational amplifier (610);
   a controller (520) is configured to generate a first control voltage (VC1) and a second control voltage (VC2) for controlling the first poly-resistor (510), and further generate a third control voltage (VC3) and a fourth control voltage (VC4) for controlling the second poly-resistor (530), wherein the first control voltage (VC1), the second control voltage (VC2), the third control voltage (VC3), and the fourth control voltage (VC4) are determined according to the positive output voltage (VOP), the negative output voltage (VON), and the inner voltage (VAV); and
   an auxiliary operational amplifier (620) that compares the inner voltage (VAV) with a common voltage (VCM), so as to adjust the output common-mode voltage of the main operational amplifier (610) with a negative feedback mechanism.

2. The differential or pseudo-differential amplifier (600A, 600B, 600C, 600D) of claim 1, wherein the common voltage (VCM) is set to a ground voltage (VSS).

3. The differential or pseudo-differential amplifier (600A, 600B) of any of claims 1 or 2 further comprising a third resistor (R1) coupled between a negative input voltage (VIN) and the negative input terminal of the main operational amplifier (610).

4. The differential or pseudo-differential amplifier (600A, 600B) of claim 3, further comprising a fourth resistor (R2) coupled between a positive input voltage (VIP) and the positive input terminal of the main operational amplifier (610).

## Patentansprüche

1. Differenz- oder Pseudo-Differenzverstärker (600A, 600B, 600C, 600D), umfassend:

   einen Hauptoperationsverstärker (610);
   einen ersten Widerstand (R3), der zwischen einem negativen Eingangsanschluss und einem positiven Ausgangsanschluss (VOP) des Hauptoperationsverstärkers (610) gekoppelt ist;
   einen zweiten Widerstand (R4), der zwischen einem positiven Eingangsanschluss und einem negativen Ausgangsanschluss (VON) des Hauptoperationsverstärkers (610) gekoppelt ist;
   einen ersten Polywiderstand (510);
   einen zweiten Polywiderstand (530), wobei eine innere Spannung (VAV) zwischen dem ersten Polywiderstand (510) und dem zweiten Polywiderstand (530) besteht, wobei der erste Polywiderstand (510) zwischen dem positiven Ausgangsanschluss (VOP) des Hauptoperationsverstärkers (610) und der inneren Spannung (VAV) gekoppelt ist, wobei der zweite Polywiderstand (530) zwischen der inneren Spannung (VAV) und dem negativen Ausgangsanschluss (VON) des Hauptoperationsverstärkers (610) gekoppelt ist;
   eine Steuereinheit (520), die so konfiguriert ist, dass sie eine erste Steuerspannung (VC1) und eine zweite Steuerspannung (VC2) zum Steuern des ersten Polywiderstands (510) erzeugt und weiter eine dritte Steuerspannung (VC3) und eine vierte Steuerspannung (VC4) zum Steuern des zweiten Polywiderstands (530) erzeugt, wobei die erste Steuerspannung (VC1), die zweite Steuerspannung (VC2), die dritte Steuerspannung (VC3) und die vierte Steuerspannung (VC4) gemäß der positiven Ausgangsspannung (VOP), der negativen Ausgangsspannung (VON) und der inneren Spannung (VAV) bestimmt werden; und

einen Hilfsoperationsverstärker (620), der die innere Spannung (VAV) mit einer gemeinsamen Spannung (VCM) vergleicht, um die Ausgangs-Gleichtakt-Spannung des Hauptoperationsverstärkers (610) mit einem negativen Rückkopplungsmechanismus anzupassen.

2. Differenz- oder Pseudo-Differenzverstärker (600A, 600B, 600C, 600D) nach Anspruch 1, wobei die gemeinsame Spannung (VCM) auf eine Massespannung (VSS) eingestellt wird.

3. Differenz- oder Pseudo-Differenzverstärker (600A, 600B) nach einem der Ansprüche 1 oder 2, weiter umfassend einen dritten Widerstand (R1), der zwischen einer negativen Eingangsspannung (VIN) und dem negativen Eingangsanschluss des Hauptoperationsverstärkers (610) gekoppelt ist.

4. Differenz- oder Pseudo-Differenzverstärker (600A, 600B) nach Anspruch 3, weiter umfassend einen vierten Widerstand (R2), der zwischen einer positiven Eingangsspannung (VIP) und dem positiven Eingangsanschluss des Hauptoperationsverstärkers (610) gekoppelt ist.

## Revendications

1. Amplificateur différentiel ou pseudo-différentiel (600A, 600B, 600C, 600D), comprenant :

un amplificateur opérationnel principal (610) ;
une première résistance (R3) couplée entre une borne d'entrée négative et une borne de sortie positive (VOP) de l'amplificateur opérationnel principal (610) ;
une deuxième résistance (R4) couplée entre une borne d'entrée positive et une borne de sortie négative (VON) de l'amplificateur opérationnel principal (610) ;
une première polyrésistance (510) ;
une seconde polyrésistance (530), une tension interne (VAV) étant comprise entre la première polyrésistance (510) et la seconde polyrésistance (530), la première polyrésistance (510) étant couplée entre la borne de sortie positive (VOP) de l'amplificateur opérationnel principal (610) et la tension interne (VAV), la seconde polyrésistance (530) étant couplée entre la tension interne (VAV) et la borne de sortie négative (VON) de l'amplificateur opérationnel principal (610) ;
un moyen de commande (520) est configuré pour générer une première tension de commande (VC1) et une deuxième tension de commande (VC2) pour commander la première polyrésistance (510), et génère en outre une troisième tension de commande (VC3) et une quatrième tension de commande (VC4) pour commander la seconde polyrésistance (530), dans lequel la première tension de commande (VC1), la deuxième tension de commande (VC2), la troisième tension de commande (VC3) et la quatrième tension de commande (VC4) sont déterminées selon la tension de sortie positive (VOP), la tension de sortie négative (VON) et la tension interne (VAV) ; et
un amplificateur opérationnel auxiliaire (620) qui compare la tension interne (VAV) à une tension commune (VCM), de manière à ajuster la tension de mode commun de sortie de l'amplificateur opérationnel principal (610) avec un mécanisme de rétroaction négative.

2. Amplificateur différentiel ou pseudo-différentiel (600A, 600B, 600C, 600D) selon la revendication 1, dans lequel la tension commune (VCM) est définie sur une tension de masse (VSS).

3. Amplificateur différentiel ou pseudo-différentiel (600A, 600B) selon l'une quelconque des revendications 1 ou 2, comprenant en outre une troisième résistance (R1) couplée entre une tension d'entrée négative (VIN) et la borne d'entrée négative de l'amplificateur opérationnel principal (610).

4. Amplificateur différentiel ou pseudo-différentiel (600A, 600B) selon la revendication 3, comprenant en outre une quatrième résistance (R2) couplée entre une tension d'entrée positive (VIP) et la borne d'entrée positive de l'amplificateur opérationnel principal (610).

FIG. 1

FIG. 2

310

211(V1)  220  340  212(V2)

VC1  221  VC2

331  332

342  342

N+  N+

N-type Doped Layer  330

P-type Doped Layer  350

FIG. 3

410

211(V1)  220  440  212(V2)

VC1  221  VC2

431  432

442  442

P+  P+

P-type Doped Layer  430

N-type Doped Layer  450

FIG. 4

500A

511(V1)    510    512(V2)    530    532(V3)

Poly-Resistor    Poly-Resistor

531

VC1    VC2  VC3    VC4

Controller    520

FIG. 5A

500B

511(V1)    510    512(V2)    531(V3)    530    532(V4)

Poly-Resistor    Poly-Resistor

VC1    VC2    VC3    VC4

Controller    550    Controller    560

FIG. 5B

FIG. 6A

FIG. 6B

FIG. 6C

FIG. 6D

700A

FIG. 7A

700B

FIG. 7B

700C

FIG. 7C

700D

FIG. 7D

800A

FIG. 8A

800B

FIG. 8B

800C

VC1    VC2

Poly-Resistor  — 110

VIN    IIN

VOP

120

Controller

610

VCM

FIG. 8C

900

FIG. 9

1000

FIG. 10

EP 3 998 647 B1

1100

FIG. 11

FIG. 12

EP 3 998 647 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011248787 A

**Non-patent literature cited in the description**

- Very low-cost CMOS audio amplifier for I-V portable applications. **AZZOLINI C et al.** Design and Technology of Integrated Systems in Nanoscale Era, 2008, DTIS 2008, 3rd International Conference on. IEEE, 25 March 2008, 1-4

- On the Design of a Programmable-Gain Amplifier with Built-In Compact DC-Offset Cancellers for Very Low-Voltage WLAN Systems. **PUI-IN MAK et al.** IEEE Transactions on Circuits and Systems I: Regular Papers. IEEE, 02 March 2008, vol. 55, 496-509